# EUROPÄISCHE PATENTSCHRIFT

(11) **EP 1 895 030 B1**
(45) Veröffentlichungstag und Bekanntmachung des Hinweises auf die Patenterteilung: **30.03.2011**
(21) Anmeldenummer: 07114918.1
(22) Anmeldetag: 24.08.2007
(51) Int. Cl.: C30B 29/06, C30B 15/34, C30B 15/14, C30B 15/22

(54) **Verfahren und Anordnung zur Herstellung eines Rohres**
Method and assembly for manufacturing a tube
Procédé et agencement de fabrication d'un tuyau

(30) Priorität: 04.09.2006 DE 102006041736
(43) Veröffentlichungstag der Anmeldung: 05.03.2008
(73) Patentinhaber: SCHOTT Solar AG, 55122 Mainz (DE)
(72) Erfinder: Seidl, Albrecht, Dr., 63843 Niedernberg (DE); Schwirtlich, Ingo, Dr., 63897 Miltenberg (DE)
(74) Vertreter: Stoffregen, Hans-Herbert

(56) Entgegenhaltungen:
- DE-A1- 2 325 104
- US-A- 4 116 641
- US-A- 4 242 589
- US-A1- 2002 144 649
- BEHNKEN H ET AL: "A 3D dynamic stress model for the growth of hollow silicon polygons" JOURNAL OF CRYSTAL GROWTH, ELSEVIER, AMSTERDAM, NL, Bd. 275, Nr. 1-2, 15. Februar 2005 (2005-02-15), Seiten e375-e380, XP004823275 ISSN: 0022-0248
- MACKINTOSH ET AL: "Large silicon crystal hollow-tube growth by the edge-defined film-fed growth (EFG) method" JOURNAL OF CRYSTAL GROWTH, ELSEVIER, AMSTERDAM, NL, Bd. 287, Nr. 2, 25. Januar 2006 (2006-01-25), Seiten 428-432, XP005248239 ISSN: 0022-0248

## Beschreibung

Die Erfindung bezieht sich auf ein Verfahren zur Herstellung eines kristallinen Rohres aus einem Material wie Silizium durch Ziehen des Rohres aus einer Schmelze, die durch Aufschmelzen des einem Schmelztiegel zugeführten Materials mittels einer Heizung erzeugt wird, wobei die Schmelze einen die Geometrie des Rohres vorgebenden kapillaren Spalt durchsetzt und diesen mit einem Meniskus einer Höhe h überragt, der in einen der Geometrie des Rohres entsprechenden Keim bzw. unteren Randbereich eines gezogenen Abschnitts des herzustellenden Rohrs übergeht. Ferner nimmt die Erfindung Bezug auf eine Anordnung zum Ziehen eines Rohres aus einer Schmelze umfassend einen Schmelztiegel mit einem die Geometrie des Rohres vorgebenden von der Schmelze durchsetzten kapillaren Spalt, der von der Schmelze mit einem Meniskus eine Höhe h überragt ist, und zumindest eine dem Schmelztiegel zugeordnete Heizung sowie eine das Rohr ziehende Zieheinrichtung.

Ein entsprechendes Verfahren ist auch als EFG (Edge-Definded-Film-Fed-Growth) - Verfahren bekannt, mit dem mehreckige wie insbesondere 8-eckige Rohre aus einer Schmelze wie Silizium-Schmelze gezogen werden. Übliche Kantenabstände betragen 125 mm. Aus den entsprechenden Seiten werden sodann Scheiben mittels Laser ausgeschnitten, die Kantenlängen von 100 x 100 mm oder größer aufweisen.

Anordnungen, mit denen EFG-Verfahren durchgeführt werden, sind hinlänglich bekannt und umfassend beschrieben. Insoweit wird beispielhaft auf die EP-B-0 369 574 oder die US-B-6,562,132 sowie die diesen Dokumenten zu entnehmenden Literaturstellen verwiesen. Dabei wird nach der US-B-6,562,132 das Zuführen von aufzuschmelzenden Siliciumpartikeln bzw. das elektromagnetische Feld von Induktionsspulen zur Erwärmung der Schmelze geregelt.

Die DE-T-691 24 441 hat ein System zum Regeln einer Anlage zum Kristallzüchten zum Gegenstand. Um Rohre mit einheitlicher Wandstärke zu ziehen, wird vorgeschlagen, dass das Ist-Gewicht des anwachsenden Kristallkörpers als Regelgröße benutzt wird, um im erforderlichen Umfang der Schmelze Material zuzuführen.

Die US-A-4,544,528 beschreibt eine Vorrichtung zum Ziehen von Rohren nach dem EFG-Verfahren. Dabei zeichnet sich die Vorrichtung dadurch aus, dass im Bereich des Übergangs von Schmelze und erstarrtem Rohr Hitzeschilder vorgesehen sind. Ferner sind innere und äußere Nachheizeinrichtungen im Bereich des erstarrten Rohres eingebaut.

Die DE-A-23 25 104 bezieht sich auf Kristallziehverfahren für Rohre bzw. Fäden. Um den Außendurchmesser der Rohre innerhalb vorgeschriebener Grenzen zu halten, wird die Höhe des Meniskus gemessen und in Abhängigkeit von dessen Höhe die Temperatur geregelt.

Um Einkristalle zu züchten, wird nach der RU-C-2 222 646 sowie der RU-C-2 230 839 ein eine Schmelze aufnehmender Tiegel benutzt, in dem ein Formgeber mit Kanälen angeordnet ist , die von der Schmelze durchsetzt werden. Die Kanäle enden im oberen Bereich des Formgebers bei einem Impfkristall. Zum Aufschmelzen ist eine Heizvorrichtung vorgesehen, die aus U-förmigen Lamellen besteht, die entsprechend der Form des Tiegels gebogen sind. Die Lamellen sind in Sektionen angeordnet, um radial verlaufende isothermische Zustände zu erzielen.

Die NL.Z.: BEHNKEN, H.; SEIDL, A.; FRANKE, D.: A 3D dynamic stress modul for the growth of hollow silicon polygons In: Journal of Crystal Growth, 2005, Vol. 275, S. e375 - e380 beschreibt das Ziehen von Rohren nach dem EFG-Verfahren. Gleiches ist der NL.Z.: MACKINTOSH ET AL: "Large silicon crystal hollow-tube growth by the edge-defined film-fed growth (EFG) method" JOURNAL OF CRYSTAL GROWTH, ELSEVIER, AMSTERDAM, NL, Bd. 287, Nr. 2, 25. Januar 2006 (2006-01-25); Seiten 428-432, XP005248239 ISSN: 0022-0248, zu entnehmen. Die US-A-4,116,641 bezieht sich auf ein Verfahren zum Ziehen eines aus Silizum bestehenden Bandes nach dem EFG-Verfahren. Dabei können Bereiche der Schmelze des Siliziummaterials, aus dem das Band gezogen wird, unabhängig voneinander temperiert werden, um im Meniskus-Bereich eine gewünschte Temperatur einstellen zu können.

Zum Ziehen eines Bandes aus einer Silizium-Schmelze wird nach der US-A-4,242,589 gleichfalls das EFG-Verfahren eingesetzt. Zum Schmelzen des Siliziums werden Heizelemente verwendet, deren Leistungen zur Einstellung der Wachstumsgeschwindigkeit einstellbar sind.

Der vorliegenden Erfindung liegt die Aufgabe zu Grunde, ein Verfahren und eine Anordnung der eingangs genannten Art so weiterzubilden, dass Rohre herstellbar sind, die eine gewünschte gleich bleibende Wandstärke aufweisen, also eine enge Dickenverteilung zeigen. Dabei soll insbesondere der mittlere Einsatz des Materials, aus dem das Rohr gezogen wird, minimiert werden. Insbesondere sollen bei der Herstellung von aus Silizium bestehenden Wafern Dicken erzielbar sein, die zu einem hohen Füllgrad und somit hohen Wirkungsgrad einer Solarzelle führen.

Erfindungsgemäß wird die Aufgabe im Wesentlichen durch ein Verfahren der eingangs genannten Art dadurch gelöst, dass die Temperatur in einzelnen Bereichen der Schmelze unabhängig voneinander in Abhängigkeit von der Wandstärke t des aus dem jeweiligen Bereich gezogenen Rohrabschnitts durch Regelung eingestellt wird.

Mit diesem Verfahren sind erfindungsgemäße Rohre nach Anspruch 18 zugänglich.

Abweichend vom Stand der Technik wird zum Ziehen von Rohren ein Regelprozess vorgeschlagen, aufgrund dessen reproduzierbar Rohre mit einer engen Dickenverteilung bei Minimierung der Wandstärke herstellbar sind, so dass insbesondere bei der Herstellung von Silizium-Rohren zur Herstellung von Wafern der mittlere Einsatz des Siliziums minimiert wird. Es wird folglich das Rohr aus einer Schmelze gezogen, deren Temperatur abschnitts- bzw. segmentweise geregelt eingestellt wird.

Erfindungsgemäß kann eine Regelung der Temperatur der Schmelze derart erfolgen, dass im Meniskus, und zwar im Übergangsbereich zwischen der Schmelze und dem erstarrten Rohrabschnitt, eine Temperatur herrscht, die dem Schmelzpunkt des Materials entspricht. Insbesondere beträgt die Temperatur bei Silizium als dem Material 1412 °C ± 2 °C, wobei die Temperatur mit einer Genauigkeit von 0,1 °C bis 2 °C konstant gehalten wird.

Um nicht unmittelbar die Temperatur im Meniskus messen zu müssen, werden die Dicke bzw. Wandstärke t des Rohres in dem jeweiligen Bereich bzw. oberhalb von diesem als Regelgröße herangezogen, um in Abhängigkeit der gemessenen Werte die Temperaturen in dem Bereich einzustellen. Gleichzeitig kann die Ziehgeschwindigkeit entsprechend verändert werden, wobei grundsätzlich sowohl die Ziehgeschwindigkeit als auch die Temperatur geregelt werden.

Die Messung der Dicke des Rohres erfolgt vorzugsweise im oberen Randbereich der Ziehvorrichtung.

Die individuelle Regelung der Temperaturen in den einzelnen Bereichen erfolgt insbesondere dadurch, dass jedem Bereich ein gesondertes Heizelement wie vorzugsweise Widerstandsheizelement zugeordnet wird, die untereinander vorzugsweise in einer Sternschaltung verschaltet sind.

Es besteht jedoch auch die Möglichkeit, sämtlichem Bereich ein einziges Heizelement zuzuordnen. Hierbei handelt es sich vorzugsweise um ein Induktionsheizelement, d. h., dass der Schmelztiegel von einer Induktionsspule umgeben ist. Um jedoch in den einzelnen Bereichen die Temperatur entsprechend der vorzunehmenden Regelung einstellen zu können, wird das Magnetfeld in jedem Bereich individuell variiert. Hierzu sind ferritische Elemente vorgesehen, die das Magnetfeld beeinflussen. Dabei kann jedes ferritische Element, das jeweils einem Bereich zugeordnet ist, z. B. mittels eines Motors radial verstellt werden. Somit ist mit einfachen Maßnahmen die Möglichkeit gegeben, die Temperatur der Schmelze derart zu regeln, dass die erforderliche Temperaturkonstanz im Meniskus herrscht.

Bezüglich der Ziehgeschwindigkeit ist vorgesehen, dass diese auf einen Wert zwischen 7 mm/min bis 24 mm/min mit einer Toleranz von 1 mm/min eingestellt werden sollte, wobei bevorzugterweise die Ziehgeschwindigkeit zwischen 12 mm/min und 15 mm /min liegt.

Weist das Rohr eine Polygon-Geometrie auf, so ist jeder Seite des Polygons ein Bereich zugeordnet, d. h. jede Seite wird temperaturmäßig individuell geregelt. Somit sind bei einem Achteck acht Heizelemente bzw. acht unabhängig voneinander verstellbare ferritische Elemente bei der Verwendung einer Induktionsheizung vorgesehen. Bei einem Zwölfeck sind dementsprechend zwölf Heizelemente bzw. ferritische Elemente vorhanden, um die Temperaturregelung durchführen zu können.

Wird ein Widerstandsheizelement benutzt, so besteht dieses vorzugsweise aus Graphit. Metallische Widerstandsheizelemente, mit denen die erforderlichen Temperaturen zum Einstellen der Schmelztemperaturen erzeugbar sind, kommen gleichfalls in Frage.

Die Temperatur der Schmelze wird konstruktionsbedingt häufig nicht unmittelbar gemessen. Vielmehr wird die Temperatur der Wandung des Schmelzbades z. B. mit einem Pyrometer ermittelt. Es besteht jedoch auch die Möglichkeit, z. B. mittels eines Thermoelementes unmittelbar die Schmelztemperatur zu erfassen.

Um die Höhe h des Meniskus, also den Übergang zwischen fester und flüssiger Phase zu messen, wird ein optischer Sensor benutzt. Insbesondere ist eine CCD-Kamera mit Bildverarbeitung vorgesehen. Hierzu können in der Ummantelung des Schmelzbades Sichtfenster vorhanden sein, um in jedem Bereich die Höhe h des Meniskus zu ermitteln.

Die Wandstärke des aus dem Bereich herausgezogenen Rohrabschnitts kann interferometrisch, wie z. B. mit einem IR-Interferometer gemessen werden. Die Messeinrichtungen für die Wandstärkenmessung bzw. die Höhe des Meniskus werden mit einem Regler verbunden, über den sodann die Heizung für die einzelnen Bereiche geregelt wird. Von dem Regler kann auch die Ziehgeschwindigkeit vorgegeben werden.

Des Weiteren wird das aufzuschmelzende Material derart in den Schmelztiegel eingegeben, dass jedem Bereich die Menge zugeführt wird, die der Menge entspricht, die aus der Schmelze abgezogen worden ist. Hierzu sind das Rohr und die Materialzuführung jeweils mit einer Wägezelle verbunden, um die erforderliche Regelung vornehmen zu können.

Aufgrund der erfindungsgemäßen Lehre besteht im Vergleich zu vorbekannten EFG-Verfahren zur Herstellung von Rohren die Möglichkeit, großtechnisch Rohre mit einem Umfang von 1,50 m oder mehr und einer Länge von mehr als 6 m herzustellen, wobei die Wandstärke eine enge Dickenverteilung aufweist. Insbesondere besteht die Möglichkeit, Rohre mit Wanddicken zwischen 100 µm und 300 µm mit einer Toleranz zwischen 8 bis 12 % herzustellen. Handelt es sich bei dem gezogenen Rohr um Silizium, können folglich Silizium-Wafer gewünschter Größen, insbesondere mit Kantenlängen von bis zu 156 mm (6 inch), Wanddicken unter 350 µm, insbesondere unter 290 µm hergestellt werden, so dass sich ein hoher Füllfaktor, eine hohe Kurzschlussstromdichte und eine hohe Leerlaufspannung einer aus dem Wafer hergestellten Solarzelle aus polykristallinem Silizium ergibt, Werte, die mit der erfindungsgemäß erzielbaren Reproduzierbarkeit nach dem Stand der Technik zumindest großtechnisch nicht zur Verfügung stehen.

Das Verfahren der eingangs genannten Art zeichnet sich insbesondere dadurch aus, dass die Temperatur der Schmelze - vorzugsweise in einander angrenzenden Bereichen unabhängig voneinander - derart geregelt wird, dass die Temperatur des Meniskus über die gesamte Länge des Spaltes auf einen konstanten oder nahezu konstanten Wert gehalten wird und/oder die Temperatur aneinander grenzender Bereiche des Schmelztiegels unabhängig voneinander in Abhängigkeit von der Wandstärke t des aus dem Bereich gezogenen Rohrabschnitts geregelt wird und/oder die Ziehgeschwindigkeit des aus der Schmelze gezogenen Rohrabschnitts in Abhängigkeit von der Höhe h des Meniskus und/oder der Wandstärke t des Rohrabschnitts geregelt wird.

Eine Anordnung der eingangs genannten Art zeichnet sich dadurch aus, dass aneinander grenzende Bereiche des Schmelztiegels und/oder der Schmelze unabhängig voneinander mittels der einen Heizung oder mehrerer Heizungen in Abhängigkeit von mittels jedem Bereich zugeordneten ersten Messeinrichtungen gemessener Wandstärke t des Bereichs temperierbar sind.

Es besteht jedoch auch die Möglichkeit, dass sämtlichen Bereichen ein Induktionsheizelement wie -spule zugeordnet ist, wobei jedem Bereich ein das Magnetfeld des Induktionsheizelements beeinflussendes ferritisches Element zugeordnet ist, die unabhängig voneinander verstellbar sind. Insbesondere ist jedes ferritische Element mittels eines Motors verstellbar.

Die Sensoren zur Messung der Wandstärke t sollten in hinreichendem Abstand zur Schmelze, vorzugsweise im oberen Randbereich der Ziehanlage bzw. deren Gehäuses angeordnet sein.

In Weiterbildung sieht die Erfindung vor, dass die die Wandstärke t des aus dem Bereich gezogenen Rohrabschnitts messende erste Messeinrichtung ein Interferometer wie IR-Interferometer ist.

In Weiterbildung ist vorgesehen, dass jeweiligem Bereich eine die Höhe h des Meniskus messende zweite Messeinrichtung zugeordnet ist, bei der es sich insbesondere um eine CCD-Kamera mit angeschlossener Bildverarbeitung handelt.

Die erste und/oder zweite Messeinrichtung und die die Bereiche temperierbaren Heizungen sind über einen Regler verbunden, der auch mit der Zieheinrichtung verbunden sein sollte.

Ein Rohr, das nach dem erfindungsgemäßen Verfahren hergestellt ist, zeichnet sich insbesondere dadurch aus, dass das Rohr einen Umfang U mit U ≥ 150 cm, eine Länge L mit L ≥ 600 cm und eine Wandstärke t mit 100 µm ≤ t ≤ 500 µm aufweist. Bevorzugterweise weist das Rohr eine Zwölfeckgeometrie auf.

Bevorzugte Wandstärken des Rohres liegen zwischen 250 µm und 350 µm bei einer Dickentoleranz zwischen 20% und 30 % bzw. zwischen 100 µm und 240 µm bei einer Dickentoleranz zwischen 8 % und 12 %.

Bei der Verwendung von Widerstandheizelementen als die die einzelnen Bereiche temperierenden Heizungen ist in Weiterbildung der Erfindung vorgesehen, dass die Anordnung von einem aus Metall bestehenden Gehäuse umgeben ist, eine Möglichkeit, die bei dem Einsatz einer Induktionsheizung nicht möglich ist. Die metallische Einhausung weist kopfseitig einen der Geometrie des Rohres entsprechenden Durchbruch zur Durchführung des Rohres auf. Die Widerstandsheizelemente sollten bevorzugterweise aus Graphit bestehen.

Im Kopfbereich der Einhausung befinden sich vorzugsweise die Sensoren zur Wandstärkenmessung.

Zur Temperaturmessung sind Temperatursensoren wie Pyrometer oder Thermoelemente vorgesehen, wobei mittels der Pyrometer die Bodenwandung des Schmelztiegels gemessen wird, um somit Rückschlüsse auf die Schmelztemperatur selbst ziehen zu können.

Der Schmelztiegel weist eine ringförmige Geometrie auf, wobei der Außendurchmesser 5 % bis 15 % größer als größte Diagonale des Rohres ist.

Der kapillare Spalt ist über eine Vielzahl von kleinen Bohrungen bzw. Schlitzen mit dem Schmelztiegel, d. h. der in diesem vorhandenen Schmelze verbunden. Weist der Spalt eine Polygon-Geometrie auf, so ist jeder Seite des Polygons einer der Bereiche zugeordnet, die unabhängig voneinander temperierbar ist.

Um das aufzuschmelzende Material dem Schmelztiegel zuzuführen, führt eine Zuführeinrichtung durch den Boden der Anordnung, um sodann das Material über eine Umlenkeinrichtung gleichmäßig über die einzelnen Bereiche des Schmelztiegels zu verteilen: Oberhalb des Schmelztiegels ist das aus der Schmelze herausgezogene Rohr von Isolationselementen umgeben, um eine gezielte Abkühlung zu ermöglichen.

Weitere Einzelheiten, Vorteile und Merkmale der Erfindung ergeben sich nicht nur aus den Ansprüchen, den diesen zu entnehmenden Merkmalen -für sich und/oder in Kombination-, sondern auch aus der nachfolgenden Beschreibung von der Zeichnung zu entnehmenden bevorzugten Ausführungsbeispielen.

Es zeigen:
- Fig. 1: eine Prinzipdarstellung einer ersten Ausführungsform einer Anordnung zum Ziehen von einem Rohr aus einer Schmelze,
- Fig. 2: ein Detail der Anordnung gemäß Fig. 1,
- Fig. 3: ein Ersatzschaltbild,
- Fig. 4: eine Prinzipdarstellung einer zweiten Ausführungsform einer Anordnung zum Ziehen eines Rohres aus einer Schmelze,
- Fig. 5: ein Detail der Anordnung gemäß der Fig. 4 und
- Fig. 6: eine Prinzipdarstellung zur Ermittlung einer Stellgröße.

In den Figuren, in denen grundsätzlich für gleiche Elemente gleiche Bezugszeichen verwendet werden, sind Anordnungen bzw. Details dieser zu entnehmen, mit denen Rohre nach dem EFG-Verfahren gezogen werden. Allerdings ist die Erfindung dabei nicht auf Rohre polygonaler Geometrie beschränkt. Vielmehr können die Rohre auch im Schnitt eine Kreisgeometrie aufweisen.

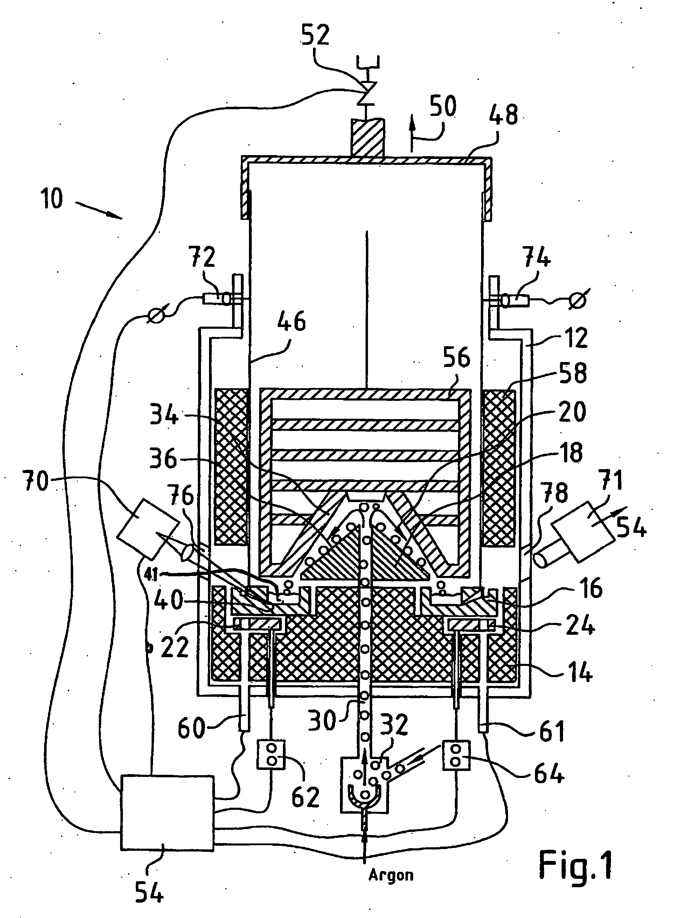

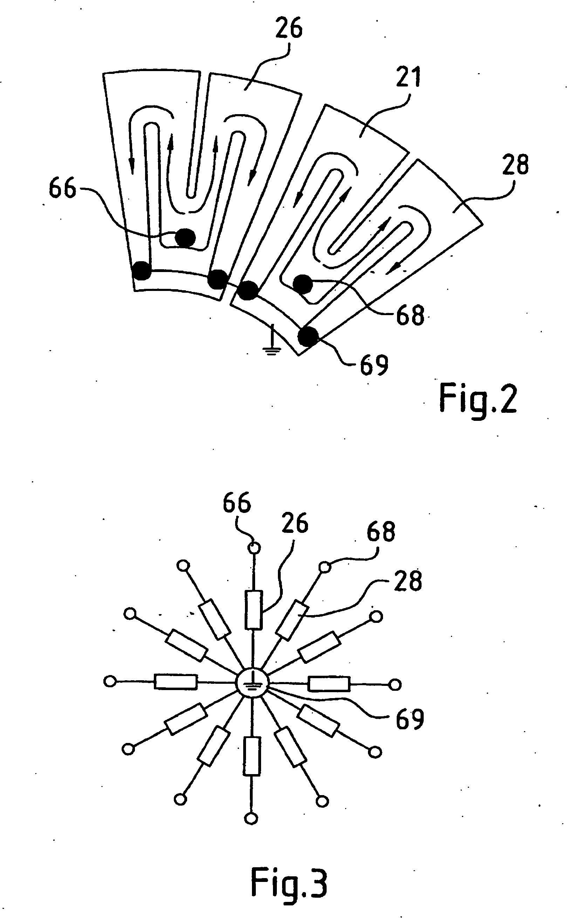

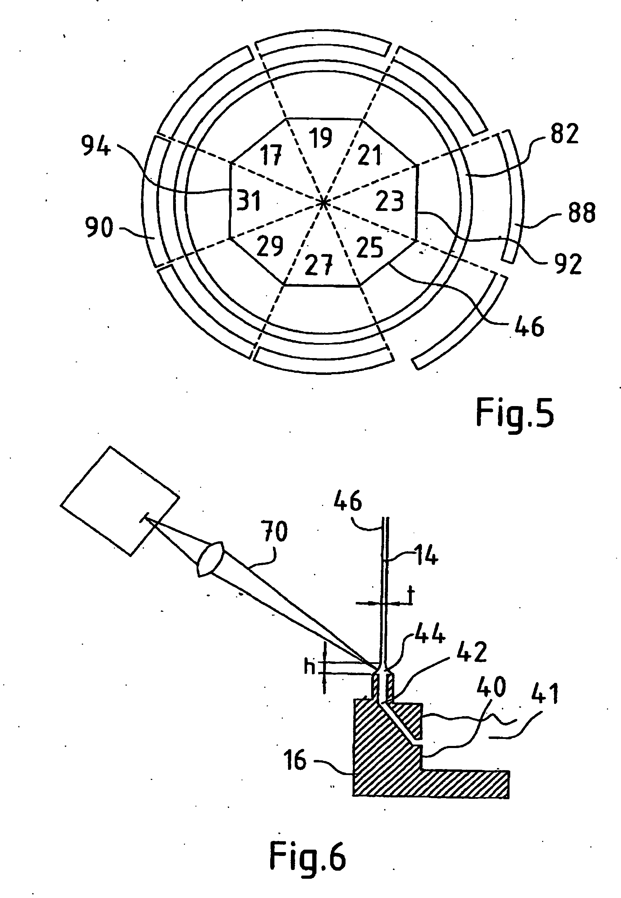

Die Anordnung 10 weist entsprechend der Darstellung gemäß Fig. 1 ein auch als Rezipient zu bezeichnendes Gehäuse 12 auf, das eine Bodenisolierung 14 aufnimmt, in dem ein ringförmiger Schmelztiegel 16 angeordnet ist. In dem Schmelztiegel 16 wird über eine Zuführeinrichtung 18 eingebrachtes Material 20 aufgeschmolzen, und zwar im Ausführungsbeispiel der Fig. 1 bzw. Fig. 2 mittels Widerstandsheizelementen 22, 24, 26, 28, über die aneinandergrenzende Bereiche des Schmelztiegels 16 unabhängig voneinander beheizbar sind. Eine entsprechende Aufteilung ist in Fig. 5 angedeutet und mit den Bezugszeichen 17, 19, 21, 23, 25, 27, 29, 31 gekennzeichnet.

Das Material, das dem Schmelztiegel 16 zugeführt wird, kann eine kugelförmige, polygonale oder staubförmige Morphologie aufweisen und wird über eine den Boden des Gehäuses 12 und die Bodenisolierung 14 durchsetzende Öffnung 30 mittels einer Einblasvorrichtung 32 eingebracht, wobei eine Umlenkung über ein materialseitig eine kegelförmige Geometrie aufweisendes Element 34, das der Geometrie eines Schirmes ähnelt, erfolgt, so dass das dem Grunde nach ein Granulat bildende Material entlang der Oberfläche 36 eines Kegelelements in Richtung des Schmelztiegels 16, d.h. dessen ringförmig ausgebildete Aufnahme 40 geführt wird. Dabei erfolgt eine gleichmäßige Verteilung des Granulats über den gesamten Umfang der ringförmigen Aufnahme 40.

Im Außenbereich des Schmelztiegels 16 verläuft ein der Fig. 6 zu entnehmender eine Kapillarwirkung erzeugender Spalt 42, der mit der Siliziumschmelze 41 über Schlitze oder Bohrungen verbunden ist, so dass die Schmelze 41 in den Spalt 42 fließt und aufgrund der Kapillarwirkung aus diesem kopfseitig, also am oberen Rand heraustritt und einen Meniskus 44 bildet. Der Meniskus 44 erstarrt in seinem oberen Spitzenbereich beim Ziehen eines Rohrs 46, so dass entsprechend das Rohr 46 bzw. die erstarrten Abschnitte mittels einer Zugeinrichtung 48 in Richtung des Pfeils 50 angehoben werden. Um die Menge des dem Schmelztiegel 60 zuzuführenden Granulats 20 exakt auf die Menge des abgezogenen Rohrabschnitts abzustimmen, ist die Zieheinrichtung 48 mit einer Wägezelle 52 verbunden, deren Messwerte einem Regler 54 zugeführt werden.

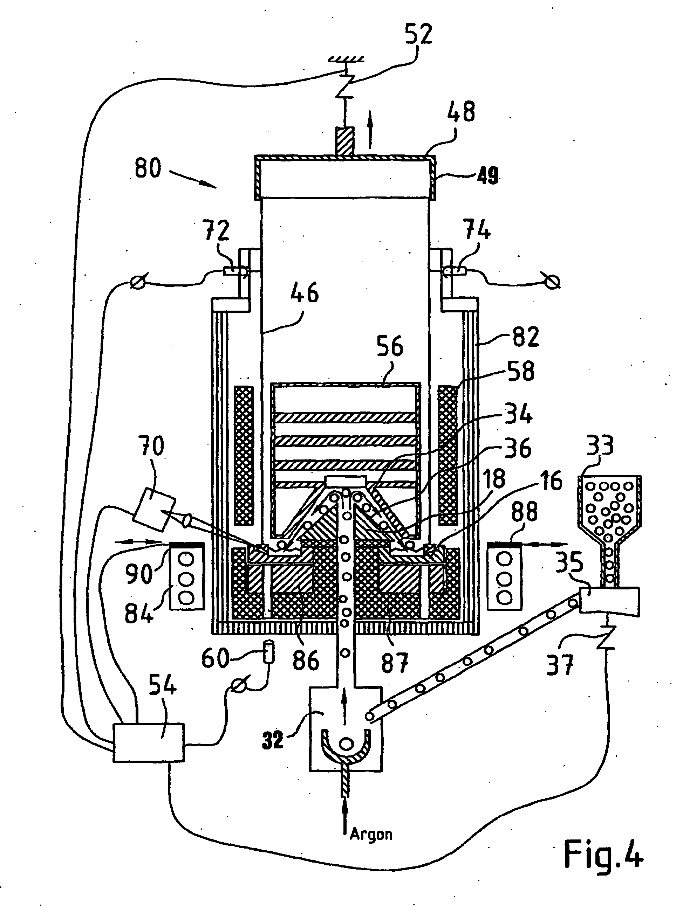

Der Einblasvorrichtung 32 wird das aufzuschmelzende Material von einer Vorlage 33 über eine Dosiereinrichtung 35 zugeführt (Fig. 4). Die Dosiereinrichtung 35 ist über eine Wägezelle 37 mit dem Regler 54 verbunden, damit über die Einblasvorrichtung 32 dem Schmelztiegel 16 genau die Menge an aufzuschmelzendem Material zugeführt wird, die aus der Schmelze, d.h. dem kapillaren Spalt 42 abgezogen wird. Diese Menge wird mittels der Wägezelle 52 ermittelt.

Die Zieheinrichtung 48 umfasst einen Keimhalter 49, der zu Beginn des Ziehvorganges einen der Geometrie des zu ziehenden Rohres entsprechenden Keim aufweist, der mit dem Meniskus 44 kontaktiert wird.

Des Weiteren ist das Rohr 46 oberhalb des Schmelztiegels von einer Isolation 58 bzw. Strahlungsschilder 56 umgeben, um die Abkühlung des Rohrs 46 gesteuert vorzunehmen können.

Um den Ziehprozess zu regeln, wobei sichergestellt sein soll, dass das Rohr 46 eine reproduzierbare Wandstärke bei enger Dickenverteilung aufweist, wobei gleichzeitig die Wandstärke derart eingestellt wird, dass der Einsatz des Materials wie Silizium minimiert wird, ist erfindungsgemäß vorgesehen, dass die Schmelze in dem Schmelztiegel 16 in den aneinandergrenzenden Bereichen 17, 19, 21, 23, 25, 27, 29, 31 individuell temperierbar ist, wobei bei einem Rohr polygonaler Geometrie jeder Bereich dem einer Seite des Polygons entspricht. Weist demgegenüber das Rohr eine im Schnitt Kreisgeometrie auf, so werden die individuell zu temperierenden Bereiche auf eine Breite des Rohrs abgestimmt, in dem aus dem Rohr Platten ausgeschnitten werden, um z. B. als Wafer für herzustellende Solarzellen verwendet zu werden.

Um die Wandstärke mit enger Dickenverteilung reproduzierbar herstellen zu können, muss im Meniskus 44, und zwar im Übergangsbereich zwischen Fest- und Flüssigphase, die Temperatur des Schmelzpunkts des Materials 20 herrschen, also beim Silizium die Temperatur von 1412 °C, die zudem eine Konstanz aufweisen muss, die kleiner 2 °C, insbesondere im Bereich zwischen 0,1 °C und 2 °C liegt.

Erfindungsgemäß erfolgt die Regelung durch Messung der Dicke bzw. der Wandstärke t des Rohrs 46. Hierzu sind entsprechend der Darstellung der Fig. 1 Interferometer 72, 74 am oberen Rand des Gehäuses 12 vorgesehen, wobei ein Interferometer 72, 74 jeweils einem Bereich 17, 19, 21, 23, 25, 27, 29, 31 zugeordnet ist, genauso wie die Sensoren 70, 71 zur Messung der Höhe h des Meniskus 44. Weist das Rohr 46 z.B. eine 12eckgeometrie auf, so ist jeder der 12 Seiten jeweils ein optischer Sensor 70 bzw. 71 und ein Interferometer 72 bzw. 74 zugeordnet. Entsprechend der Fig. 5 sind bei einem achteckigen Rohr 46 acht Bereiche 17, 19, 21, 23, 25, 27, 29, 31 regelbar, die jeweils einer Fläche 92, 94 des Rohrs 46 zugeordnet sind.

Ergänzend kann die Temperatur des Meniskus 44 mittelbar gemessen werden, und zwar in dem Ausführungsbeispiel nach der Fig. 1 durch Messung der Temperatur des Bodens des Schmelztiegels 16 mittels Pyrometer 60, 61, die die Widerstandsheizung 22, 24, 26, 28 durchsetzen. Die Temperaturregelung erfolgt mittels des Reglers 54, der über regelbare Stromanschlüsse 62, 64, 66, 68 mit den Widerstandsheizungen 22, 24, 26, 28 verbunden ist. Dem Regler 54 werden die gemessenen Höhen h des Meniskus 44 in den einzelnen Bereichen 17, 19, 21, 23, 25, 27, 29, 31 zugeführt, um auf deren Basis die Temperatur in den Bereichen 17, 19, 21, 23, 25, 27, 29, 31 zu regeln. Die Höhen h werden mit optischen Sensoren 70, 71 gemessen. Insbesondere wird als Sensor eine CCD-Kamera mit nachgeschalteter Bildverarbeitung verwendet. Verändern sich die Höhen des Meniskus 44, so wird entsprechend die Temperatur des Heizelements 22, 24, 26, 28 und damit der Schmelze 41 verändert, um die erforderliche Höhe h des Meniskus 44 wieder zu erreichen, von der wiederum unmittelbar die Wandstärke t des Rohrs 46 abhängt (h = f (t)).

Es erfolgt demnach eine Regelung der Schmelztemperatur und damit der Temperatur des Meniskus 44 im Phasenübergang fest-flüssig über die Bestimmung der Höhe h des Meniskus 44.

Der Fig. 2 ist ein Ausschnitt der Widerstandsheizelemente zu entnehmen, die dem Schmelztiegel 16 zugeordnet sind. So sind in Fig. 2 zwei Heizelemente 26, 28 dargestellt, wobei jedes Heizelement 26, 28 einen Bereich des Heiztiegels individuell teinperiert. Dabei wird grundsätzlich ein Heizelement 26, 28 einer Seite des Rohrs 46 zugeordnet, sofern dieses eine Polygonform aufweist. Wird ein 12kantiges Rohr gezogen, so sind 12 Heizelemente vorgesehen, die entsprechend dem Ersatzschaltbild in Fig. 3 in einer Sternschaltung verbunden sind. Die Außenanschlüsse 66, 68 sind sodann mit dem Regler 54 verbunden, wohingegen die Innenanschlüsse 69 miteinander verbunden sind und an Masse liegen.

Das Gehäuse 12 besteht im Ausführungsbeispiel der Fig. 1 aus Stahl und weist eine Wasserkühlung auf. Um den Meniskus 44 optisch zu erfassen, sind entsprechend der zu temperierenden Bereiche 17, 19, 21, 23, 25, 27, 29, 31 Fenster 76, 78 in dem Gehäuse 12 eingelassen.

Das Ausführungsbeispiel der Fig. 4 unterscheidet sich von dem der Fig. 1 dahingehend, dass die durch Regelung individuell zu temperierenden Bereiche 17, 19, 21, 23, 25, 27, 29, 31 nicht über Widerstandsheizelemente erwärmt werden, sondern durch eine Induktionsheizung. Hierzu weist die Anordnung 80 ein Gehäuse 82 oder Rezipienten auf, der aus Doppelglas besteht und von einer Induktionsspule 84 umgeben ist. Um den Schmelztiegel 16 und damit die in diesem vorhandene Schmelze 41 zu erhitzen, ist unterhalb des ringförmigen Schmelztiegels 16 ein Suszeptor 86 angeordnet, über den Wärme erzeugt wird. Der Suszeptor 86 besteht aus Graphit. Dabei wird der Suszeptor 86 in gewohnter Weise von einer Isolation 87 umgeben, die sich entlang Boden- und Seitenwandung des aus Doppelmantel aus Glas bestehenden Gehäuses 82 erstreckt. Ansonsten weist die Anordnung 80 einen prinzipiellen Aufbau auf, wie dieser der Fig. 1 entspricht.

Um im gewünschten Umfang entsprechend der erfindungsgemäßen Lehre in einem Regelprozess die Bereiche 17, 19, 21, 23, 25, 27, 29, 31 der Schmelze 41 unterschiedlich zu temperieren, ist jedem Bereich 17, 19, 21, 23, 25, 27, 29, 31 ein verschiebbares Element 88, 90 aus ferritischem Material zugeordnet, über das das Magnetfeld der Induktionsspule 84 so beeinflusst wird, dass die gewünschte Erwärmung der Schmelze 41 derart erfolgt, dass der aus dem Spalt 42 heraustretende Meniskus 44 die gewünschte Temperatur, also bei Silicium die Temperatur 1412 °C bei hoher Konstanz aufweist.

Die Temperatur der Schmelze 41 wird entsprechend den Ausführungen im Zusammenhang mit Fig. 1 mittelbar gemessen, und zwar durch die Temperaturbestimmung des Schmelztiegels 16. Dies erfolgt ebenfalls über Pyrometer 60, wobei jedem individuell zu temperierenden Bereich 17, 19, 21, 23, 25, 27, 29, 31 ein Pyrometer 60 zugeordnet ist. Die Messung der Höhe h des Meniskus 44 bzw. der Dicke t der Wandstärke des Rohrs 46 erfolgt in zuvor erläuterter Form.

Anhand der Fig. 5 soll verdeutlicht werden, dass der Induktionsspule 84 entsprechend der individuell zu temperierenden Bereiche 17, 19, 21, 23, 25, 27, 29, 31 verstellbare Ferritelemente 88, 90 zugeordnet sind, wobei die Anzahl der Ferritelemente 88, 90 der Anzahl der Seiten 92, 94 des Rohrs 46 entspricht. Die Ferritelemente 88, 90 können z. B. mittels Stellmotoren radial zu dem Rohr 46 verstellt werden.

## Patentansprüche

1. Verfahren zur Herstellung eines kristallinen Rohres (46) aus einem Material wie Silizium durch Ziehen des Rohres aus einer Schmelze (41), die durch Aufschmelzen des einem Schmelztiegel (16) zugeführten Materials mittels einer Heizung (22, 24, 26, 28, 84, 86) erzeugt wird, wobei die Schmelze einen Geometrie des Rohres vorgebenden kapillaren Spalt (42) durchsetzt und diesen mit einem Meniskus (44) einer Höhe h überragt, der in einen der Geometrie des Rohres entsprechenden Keim bzw. unteren Randbereich eines gezogenen Abschnitts des herzustellenden Rohres übergeht,
**dadurch gekennzeichnet,**
**dass** die Temperatur in einzelnen Bereichen (17, 19, 21, 23, 25, 27, 29, 31) der Schmelze (41) unabhängig voneinander in Abhängigkeit von der Wandstärke t des aus dem jeweiligen Bereich gezogenen Rohrabschnitts durch Regelung eingestellt wird.

2. Verfahren nach Anspruch 1,
**dadurch gekennzeichnet,**
**dass** aus der Schmelze ein polygonales Rohr (46) gezogen und jeder Seitenfläche als ein Bereich des Rohrs ein von den anderen Bereichen (17, 19, 21, 23, 25, 27, 29, 31) unabhängig temperierbarer Bereich zugeordnet wird.

3. Verfahren nach Anspruch 1,
**dadurch gekennzeichnet,**
das jeder Bereich (17, 19, 21, 23, 25, 27, 29, 31) durch ein gesondertes Heizelement wie Widerstandsheizelement (22, 24, 26, 28) geregelt temperiert wird, wobei die Widerstandsheizelemente vorzugsweise in einer Sternschaltung verschaltet werden oder sämtliche Bereiche durch ein Induktionsheizelement (84) temperiert werden, wobei jedem Bereich ein das Magnetfeld des Induktionsheizelementes beeinflussendes ferritisches Element (88, 90) zugeordnet wird, das unabhängig von den anderen Elementen verstellbar ist, insbesondere das ferritische Element (88, 90) über einen ansteuerbaren Motor in Bezug auf das Rohr (46) radial verstellt wird.

4. Verfahren nach zumindest einem der vorhergehenden Ansprüche,
**dadurch gekennzeichnet,**
**dass** die Wandstärke t mittels eines Interferometers (72, 74) gemessen wird.

5. Verfahren zur Herstellung eines Rohres (46) aus Silizium nach Anspruch 1,
**dadurch gekennzeichnet,**
**dass** die Temperatur des Meniskus (44) auf eine Temperatur T mit T = 1.412 °C über die gesamte Länge des kapillaren Spalts (42) mit einer Genauigkeit ≤ 2 °C konstant gehalten wird.

6. Verfahren nach zumindest einem der vorhergehenden Ansprüche,
**dadurch gekennzeichnet,**
**dass** das Rohr (46) mit einer Ziehgeschwindigkeit zwischen 10 mm/min. und 24 mm/min. mit einer Toleranz von 1 mm/min, insbesondere mit einer Ziehgeschwindigkeit zwischen 12 mm/min. und 15 mm/min. aus der Schmelze (41) gezogen wird.

7. Verfahren nach dem Oberbegriff des Anspruchs 1,
**dadurch gekennzeichnet,**
**dass** die Ziehgeschwindigkeit des aus der Schmelze gezogenen Rohrabschnitts in Abhängigkeit von der Höhe h des Meniskus und/oder in Abhängigkeit der Wandstärke t des Rohrabschnitts geregelt wird.

8. Anordnung (10, 80) zum Ziehen eines Rohres (46) aus einer Schmelze (41) umfassend einen Schmelztiegel (16) mit einem Geometrie des Rohres vorgebenden und von der Schmelze durchsetzten kapillaren Spalt (42), der von der Schmelze mit einem Meniskus (44) einer Höhe h überragbar ist, und zumindest eine dem Schmelztiegel zugeordnete Heizung (22, 24, 26, 28, 84, 86) sowie eine das Rohr ziehende Zieheinrichtung (48),
**dadurch gekennzeichnet,**
**dass** aneinander grenzende Bereiche (17, 19, 21, 23, 25, 27, 29, 31) des Schmelztiegels (16) und/oder der Schmelze (41) unabhängig voneinander mittels der einen Heizung oder mehrerer Heizungen (22, 24, 26, 28, 84) in Abhängigkeit von mittels jedem Bereich zugeordneten ersten Messeinrichtungen (72, 74) gemessener Wandstärket des Bereichs temperierbar sind.

9. Anordnung nach Anspruch 8,
**dadurch gekennzeichnet,**
**dass** jedem Bereich (17, 19, 21, 23, 25, 27, 29, 31) ein z. B. aus Graphit bestehendes Widerstandsheizelement (22, 24, 26, 28) zugeordnet ist, wobei insbesondere die Widerstandsheizelemente (22, 24, 26, 28) in einer Sternschaltung verbunden sind.

10. Anordnung nach Anspruch 8,
**dadurch gekennzeichnet,**
**dass** sämtlichen Bereichen (17, 19, 21, 23, 25, 27, 29, 31) ein Induktionsheizelement (84) zugeordnet und jedem Bereich ein das Magnetfeld des Induktionsheizelementes beeinflussendes ferritisches Element (88, 90) zugeordnet ist, wobei die ferritischen Elemente unabhängig voneinander, insbesondere mittels eines oder mehrerer Motoren radial zu dem Rohr (46) verstellbar sind.

11. Anordnung nach zumindest einem der Ansprüche 8 bis 10,
**dadurch gekennzeichnet,**
**dass** jedem individuell beheizbaren Bereich (17, 19, 21, 23, 25, 27, 29, 31) eine die Höhe h des Meniskus (44) messende zweite Messeinrichtung (70, 71) wie eine CCD-Kamera mit Bildverarbeitung zugeordnet ist.

12. Anordnung nach zumindest einem der Ansprüche 8 bis 11,
**dadurch gekennzeichnet,**
**dass** die erste Messeinrichtung zur Messung der Wandstärke t ein Interferometer (72, 74) ist.

13. Anordnung nach zumindest einem der Ansprüche 8 bis 12,
**dadurch gekennzeichnet,**
**dass** die erste und/oder zweite Messeinrichtung (70, 71, 72, 74) und die die Bereiche (17, 19, 21, 23, 25, 27, 29, 31) temperierende Heizung (84) bzw. temperierenden Heizungen (22, 24, 26, 28) mit einer Regelung (54) verbunden sind, mit der die Zieheinrichtung (48) verbunden ist.

14. Anordnung nach zumindest einem der Ansprüche 8 bis 12,
**dadurch gekennzeichnet,**
**dass** der kapillare Spalt (42) eine Polygongeometrie aufweist und jeder Seite des Polygons einer der Bereiche (17, 19, 21, 23, 25, 27, 29, 31) zugeordnet ist.

15. Anordnung nach zumindest Anspruch 8,
**dadurch gekennzeichnet,**
**dass** Boden des Schmelztiegels (16) von einem Pyrometer (60, 61) erfassbar ist.

16. Anordnung nach zumindest Anspruch 8,
**dadurch gekennzeichnet,**
**dass** der Schmelztiegel (16) einen Außendurchmesser aufweist, der 5 bis 15 % größer als größte Diagonale des Rohres (46) ist und/oder dass der kapillare Spalt (42) über Schlitze oder Bohrungen mit der Schmelze (41) verbunden ist.

17. Anordnung nach zumindest Anspruch 8,
**dadurch gekennzeichnet,**
**dass** die Anordnung ein den Schmelztiegel (16) umgebendes vorzugsweise wassergekühltes Gehäuse aus Stahl aufweist.

18. Rohr (46), hergestellt nach dem Verfahren nach Anspruch 1,
**dadurch gekennzeichnet,**
**dass** das Rohr (46) eine Zwölfeckgeometrie und einen Umfang U mit U ≥ 150 cm, eine Länge L mit L ≥ 600 cm und eine Wandstärke t mit 100 µm ≤ t ≤ 500 µm aufweist.

## Claims

1. Method for manufacturing a crystalline tube (46) from a material such as silicon by drawing the tube from a melt (41) created from melting of the material introduced to a crucible (16) by means of a heater (22, 24, 26, 28, 84, 86), wherein the melt penetrates a capillary slot (42) giving the tube its geometry and projects beyond this slot with a meniscus (44) with a height h, which passes into a seed crystal corresponding to the geometry of the tube, respectively into a lower peripheral area of a drawn section of the tube to be manufactured,
**characterized in**
**that** by closed-loop control the temperature in individual areas (17, 19, 21, 23, 25, 27, 29, 31) of the melt (41) is adjusted independently from one another as a function of the wall thickness t of the tube section drawn from the respective region.

2. Method according to claim 1,
**characterized in**
**that** a polygonal tube (46) is drawn from the melt and to each lateral surface as a region of the tube is assigned a region being temperature-adjustable independently from the other regions (17, 19, 21, 23, 25, 27, 29, 31).

3. Method according to claim 1,
**characterized in**
**that** each area (17, 19, 21, 23, 25, 27, 29, 31) is temperature-controlled by a separate heating element, such as resistance heating element (22, 24, 26, 28), with the resistance heating elements being connected preferably in a star circuit or with all areas being temperature-controlled by an induction heating element (84), whereby assigned to each area is a ferritic element (88, 90), which influences the magnetic field of the induction heating element and is displaceable independently from the other elements, especially the ferritic element (88, 90) being radially displaced in relation to the tube (46) by means of a controllable motor.

4. Method according to at least one of the preceding claims,
**characterized in**
**that** the wall thickness t is measured by means of an interferometer (72, 74).

5. Method for manufacturing a tube (46) from silicon according to claim 1,
**characterized in**
**that** along the entire length of the capillary slot (42) the temperature of the meniscus (44) is kept constant at a temperature T, where T=1,412 °C, with an exactness ≤ 2 °C.

6. Method according to at least one of the preceding claims,
**characterized in**
**that** the tube (46) is drawn from the melt (41) at a drawing speed between 10 mm/min. and 24 mm/min. with a tolerance of 1 mm/min, especially with a drawing speed between 12 mm/min. and 15 mm/min.

7. Method according to the generic part of claim 1,
**characterized in**
**that** the drawing speed of the tube section drawn from the melt is controlled as a function of the height h of the meniscus and/or as a function of the wall thickness t of the tube section.

8. Arrangement (10, 80) for drawing a tube (46) from a melt (41) comprising a crucible (16) with a capillary slot (42) penetrated by the melt and defining the geometry of the tube, said capillary slot is exceedable by the melt with a meniscus (44) with a height h, and at least one heater (22, 24, 26, 28, 84, 86) assigned to the crucible, as well as a drawing device (48) drawing the tube,
**characterized in**
**that** abutting areas (17, 19, 21, 23, 25, 27, 29, 31) of the crucible (16) and/or the melt (41) are independently from each other temperature-controllable by means of the one heater or several heaters (22, 24, 26, 28, 84) as a function of wall thickness t measured by means of a first measuring device (72, 74) assigned to each area.

9. Arrangement according to claim 8,
**characterized in**
**that** a resistance heating element (22, 24, 26, 28) is assigned to each area (17, 19, 21, 23, 25, 27, 29, 31), said resistance heating element is made of e.g. graphite, with especially the resistance heating elements being connected in a star circuit.

10. Arrangement according to claim 8,
**characterized in**
**that** an induction heating element (84) is assigned to all areas (17, 19, 21, 23, 25, 27, 29, 31) and a ferritic element (88, 90) influencing the magnetic field of the induction heating element is assigned to each area, with the ferritic elements being displaceable independently from one each other, especially radially to the tube (46) by means of one or several motors.

11. Arrangement according to at least one of claims 8 to 10,
**characterized in**
**that** a second measuring device (70, 71), such as a CCD-camera with an image-processing unit, measuring the height h of the meniscus (44) is assigned to each individually heatable area (17, 19, 21, 23, 25, 27, 29, 31).

12. Arrangement according to at least one of claims 8 to 11,
**characterized in**
**that** the first measuring device for measuring the wall thickness t is an interferometer (72, 74).

13. Arrangement according to at least one of clams 8 to 12,
**characterized in**
**that** the first and/or second measuring device (70, 71, 72, 74) and the heater (84), respectively heaters (22, 24, 26, 28) adjusting the temperature of the areas (17, 19, 21, 23, 25, 27, 29, 31) are connected to a control unit (54) with which the drawing unit (48) is connected.

14. Arrangement according to at least one of claims 8 to 12,
**characterized in**
**that** the capillary slot (42) is of polygonal geometry and that to each side of the polygon is assigned one of the areas (17, 19, 21, 23, 25, 27, 29, 31).

15. Arrangement according to at least claim 8,
**characterized in**
**that** the base of the crucible (16) is detectable by a pyrometer (60, 61).

16. Arrangement according to at least claim 8,
**characterized in**
**that** the crucible (16) has an outer diameter that is 5 to 15% greater than longest diagonal of the tube (46) and/or that the capillary slot (42) is connected to the melt (41) via slits or holes.

17. Arrangement according to at least claim 8,
**characterized in**
**that** the arrangement comprises a steel housing surrounding the crucible (16), preferably said housing (12) being water-cooled.

18. Tube (46), produced according to the method of claim 1,
**characterized in**
**that** the tube (46) has a dodecagon geometry and a periphery U with U ≥ 150 cm, a length L, with L ≥ 600 cm, and a wall thickness t with 100 µm ≤ t ≤ 500 µm.

## Revendications

1. Procédé pour fabriquer un tube cristallin (46) dans un matériau tel que le silicium par étirage du tube à partir d'une fonte (41) obtenue par fusion au moyen d'un dispositif chauffant (22, 24, 26, 28, 84, 86) du matériau amené dans un creuset (16), sachant que la fonte traverse une fente capillaire (42) déterminant la géométrie du tube et fait saillie sur celle-ci avec un ménisque (44) d'une hauteur h, qui se transforme en un germe ou une zone marginale inférieure d'une section étirée du tube à fabriquer correspondant à la géométrie du tube,
**caractérisé en ce**
**que** les températures dans différentes zones (17, 19, 21, 23, 25, 27, 29, 31) de la fonte (41) sont ajustées indépendamment les unes des autres par un dispositif de réglage à boucle fermée en fonction de l'épaisseur de paroi t de la section de tube étirée à partir des zones respectives.

2. Procédé selon la revendication 1,
**caractérisé en ce**
**que** de la fonte est étiré un tube polygonal (46) et qu'à chaque face latérale en tant que zone du tube est associée une zone équilibrable en température et indépendante des autres zones (17, 19, 21, 23, 25, 27, 29, 31).

3. Procédé selon la revendication 1,
**caractérisé en ce**
**que** chaque zone (17, 19, 21, 23, 25, 27, 29, 31) est équilibrée et régulée en température par un élément de chauffage distinct tel qu'un élément de chauffage ohmique (22, 24, 26, 28), sachant que les éléments de chauffage ohmiques sont de préférence incorporés dans un montage en étoile ou que toutes les zones sont équilibrées en température par un élément de chauffage à induction (84), et qu'à chaque zone est associé un élément ferritique (88, 90) qui influence le champ magnétique de l'élément de chauffage à induction et est réglable indépendamment des autres éléments, et qu'en particulier l'élément ferritique (88, 90) est déplacé radialement par rapport au tube (46) par un moteur excitable.

4. Procédé selon au moins une des revendications précédentes,
**caractérisé en ce**
**que** l'épaisseur de paroi t est mesurée au moyen d'un interféromètre (72, 74).

5. Procédé pour fabriquer un tube (46) en silicium selon la revendication 1,
**caractérisé en ce**
**que** la température du ménisque (44) est maintenue constante sur toute la longueur de la fente capillaires (42) à une température T telle que T = 1412 °C avec une précision ≤ 2 °C.

6. Procédé selon au moins une des revendications précédentes,
**caractérisé en ce**
**que** le tube (46) est étiré à partir de la fonte (41) avec une vitesse d'étirage comprise entre 10 mm/min et 24 mm/min avec une tolérance de 1 mm/min, en particulier avec une vitesse d'étirage comprise entre 12 mm/min et 15 mm/min.

7. Procédé selon le préamble de la revendication 1,
**caractérisé en ce**
**que** la vitesse d'étirage de la section de tube étirée à partir de la fonte est régulée en fonction de la hauteur h du ménisque et/ou en fonction de l'épaisseur de paroi t de la section de tube.

8. Système (10, 80) pour étirer un tube (46) à partir d'une fonte (41), comprenant un creuset (16) avec une fente capillaire (42) déterminant la géométrie du tube et traversée par la fonte, et qui peut être coiffée par la fonte avec un ménisque (44) d'une hauteur h, et avec au moins un dispositif chauffant (22, 24, 26, 28, 84, 86) associé au creuset ainsi qu'avec un dispositif d'étirage (48) étirant le tube,
**caractérisé en ce**
**que** des zones limitrophes (17, 19, 21, 23, 25, 27, 29, 31) du creuset (16) et/ou de la fonte (41) sont équilibrables en température indépendamment les unes des autres au moyen d'un dispositif chauffant ou de plusieurs dispositifs chauffants (22, 24, 26, 28, 84) en fonction de l'épaisseur de paroi t de la zone mesurée au moyen de premiers systèmes de mesure (72, 74) associés à chaque zone.

9. Système selon la revendication 8,
**caractérisé en ce**
**qu'**un élément de chauffage ohmique (22, 24, 26, 28), par exemple constitué de graphite, est associé à chaque zone (17, 19, 21, 23, 25, 27, 29, 31), les éléments de chauffage ohmiques (22, 24, 26, 28) étant en particulier reliés dans un montage en étoile.

10. Système selon la revendication 8,
**caractérisé en ce**
**qu'**un élément de chauffage à induction (84) est associé à toutes les zones (17, 19, 21, 23, 25, 27, 29, 31) et qu'à chaque zone est associé un élément ferritique (88, 90) influençant le champ magnétique de l'élément de chauffage à induction, les éléments ferritiques pouvant être déplacés radialement par rapport au tube (46) indépendamment les uns des autres, en particulier au moyen d'un ou plusieurs moteur(s).

11. Système selon au moins une des revendications 8 à 10,
**caractérisé en ce**
**qu'**à chaque zone chauffable individuellement (17, 19, 21, 23, 25, 27, 29, 31) est associé un deuxième système de mesure (70, 71) tel qu'une caméra numérique avec traitement d'images qui mesure la hauteur h du ménisque (44).

12. Système selon au moins une des revendications 8 à 11,
**caractérisé en ce**
**que** le premier système de mesure destiné à mesurer l'épaisseur de paroi t est un interféromètre (72, 74).

13. Système selon au moins une des revendications 8 à 12,
**caractérisé en ce**
**que** le premier et/ou le deuxième système(s) de mesure (70, 71, 72, 74) et le dispositif chauffant (84) ou les dispositifs chauffants (22, 24, 26, 28) équilibrant en température les zones (17, 19, 21, 23, 25, 27, 29, 31) sont reliés à un dispositif de régulation (54) auquel est relié le dispositif d'étirage (48).

14. Système selon au moins une des revendications 8 à 12,
**caractérisé en ce**
**que** la fente capillaire (42) présente une géométrie polygonale et qu'à chaque face du polygone est associée une des zones (17, 19, 21, 23, 25, 27, 29, 31).

15. Système selon au moins la revendication 8,
**caractérisé en ce**
**que** fond du creuset (16) peut être saisi par un pyromètre (60, 61).

16. Système selon au moins la revendication 8,
**caractérisé en ce**
**que** le creuset (16) présente un diamètre extérieur supérieur de 5 à 15 % à la plus grande diagonale du tube (46) et/ou que la fente capillaire (42) est reliée à la fonte (41) par des fentes ou des perçages.

17. Système selon au moins la revendication 8,
**caractérisé en ce**
**que** le système présente un corps en acier, de préférence refroidi par eau, qui entoure le creuset (16).

18. Tube (46), fabriqué selon le procédé selon la revendication 1,
**caractérisé en ce**
**que** le tube (46) présente une géométrie dodécagonale et une circonférence U telle que U ≥ 150 cm, une longueur L telle que L ≥ 600 cm et une épaisseur de paroi t telle que 100 µm ≤ t ≤ 500 µm.
